# EUROPÄISCHE PATENTANMELDUNG

(11) **EP 4 727 259 A1**
(43) Veröffentlichungstag der Anmeldung: **15.04.2026**
(21) Anmeldenummer: 25199307.7
(22) Anmeldetag: 01.09.2025
(51) Int. Cl.: H05B 6/12

(54) **INDUKTIONSKOCHFELD**

(30) Priorität: 08.10.2024 DE 102024128942
(71) Anmelder: E.G.O. Elektro-Gerätebau GmbH, 75038 Oberderdingen (DE)
(72) Erfinder: Föller, Thomas, 74193 Schwaigern (DE)
(74) Vertreter: Patentanwälte Ruff, Wilhelm, Beier, Dauster & Partner mbB

(57) **Zusammenfassung**

Ein Induktionskochfeld weist eine Kochfeldplatte, Induktionsheizspulen darunter, eine Leistungsversorgung mit Leistungs-Halbleitern für die Induktionsheizspulen und einen elektrischen Anschluss nach außen auf, wobei die Leistungsversorgung auf einer Leistungs-Leiterplatte und der elektrische Anschluss auf einer Anschluss-Leiterplatte angeordnet sind. Es ist auch mindestens eine Kühleinrichtung vorgesehen, die mindestens einen Lüfter mit einem Lüftereingang als Ansaugung und mit einem Lüfterausgang für ausgeblasene Luft zur Kühlung der Leistungsversorgung, einen Kühlluftkanal und mindestens einen Kühlkörper aufweist, zu dem der Kühlluftkanal führt. In einer vertikalen Richtung, die rechtwinklig zur Kochfeldplatte und zu einer der Leiterplatten verläuft, ist der Lüfter tiefer als der Kühlkörper angeordnet. Dabei verläuft die Anschluss-Leiterplatte unterhalb der Leistungs-Leiterplatte, die Anschluss-Leiterplatte weist einen elektrischen Anschluss nach außen auf und der Kühlluftkanal verläuft mit einer Biegung und Umlenkung von 90° oder von 180° zwischen dem Lüfterausgang und dem Kühlkörper.

## Beschreibung

### Anwendungsgebiet und Stand der Technik

Die Erfindung betrifft ein Induktionskochfeld mit einer Kochfeldplatte und Induktionsheizspulen darunter sowie mit einer Leistungsversorgung und einem elektrischen Anschluss, wofür insgesamt zwei Leiterplatten vorgesehen sind. Des Weiteren ist eine Kühleinrichtung vorgesehen, die einen Kühler und einen Kühlluftkanal hin zu einem Kühlkörper aufweist, an welchem Leistungs-Halbleiter der Leistungsversorgung zur Kühlung angeordnet sind.

Aus der DE 10 2017 213 582 A1 ist eine Kühleinrichtung bekannt, die unter anderem auch in einem Kochfeld eingesetzt werden kann. Hier bläst ein Lüfter direkt einen Kühlkörper an.

### Aufgabe und Lösung

Der Erfindung liegt die Aufgabe zugrunde, ein eingangs genanntes Induktionskochfeld zu schaffen, mit dem Probleme des Standes der Technik gelöst werden können und es insbesondere möglich ist, einen Aufbau des Induktionskochfelds einfach und kompakt zu halten und dabei eine möglichst gute Kühlung zu erreichen.

Gelöst wird diese Aufgabe durch ein Induktionskochfeld mit den Merkmalen des Anspruchs 1. Vorteilhafte sowie bevorzugte Ausgestaltungen der Erfindung sind in den weiteren Ansprüchen enthalten und werden im Folgenden näher erläutert. Der Wortlaut der Ansprüche wird durch ausdrückliche Bezugnahme zum Inhalt der Beschreibung gemacht.

Das Induktionskochfeld weist eine Kochfeldplatte und Induktionsheizspulen darunter auf, mindestens eine Induktionsheizspule, vorteilhaft mehrere wie beispielsweise vier bis sechs Induktionsheizspulen. Das Induktionskochfeld weist auch eine Leistungsversorgung für die Induktionsheizspulen auf, welche Leistungs-Halbleiter aufweist, insbesondere für einen Wechselrichter. Eine solche Leistungsversorgung ist grundsätzlich bekannt. Das Induktionskochfeld weist noch einen elektrischen Anschluss nach außen auf, der insbesondere an einen Hausanschluss oder an einen Gebäudeanschluss geht. Die Leistungsversorgung ist auf einer Leistungs-Leiterplatte angeordnet, während der genannte elektrische Anschluss auf einer Anschluss-Leiterplatte angeordnet ist. Das Induktionskochfeld weist also mindestens diese beiden Leiterplatten auf. Schließlich weist das Induktionskochfeld noch eine Kühleinrichtung auf, welche mindestens einen Lüfter mit einem Lüftereingang und einem Lüfterausgang aufweist. Am Lüftereingang wird wie üblich Luft angesaugt, und am Lüfterausgang wird die angesaugte Luft ausgeblasen, womit dann mindestens die Leistungsversorgung gekühlt werden soll. Hierfür ist ein Kühlluftkanal für die ausgeblasene Luft vorgesehen, welcher zumindest teilweise geschlossen ist und an den Lüfterausgang anschließt, bevorzugt also zwischen Lüfter und Kühlkörper ist bzw. welcher an den Lüfter anschließt. Der Kühlluftkanal kann einen einfachen oder einen komplizierten Verlauf aufweisen, er kann kurz sein oder lang sein, wie im Nachfolgenden noch näher erläutert wird. Außerdem weist die Kühleinrichtung noch einen Kühlkörper auf, zu welchem der Kühlluftkanal führt und so die ausgeblasene Luft zur Kühlung an den Kühlkörper heranbringt, wobei der Kühlkörper Teil des Kühlluftkanals sein kann. Die genannten Leistungs-Halbleiter liegen an dem Kühlkörper an, um gekühlt zu werden. Möglicherweise können auch noch weitere Bauteile daran anliegen oder auf andere Weise zumindest indirekt durch die Kühlluft gekühlt werden, ggf. auch direkt.

Erfindungsgemäß ist vorgesehen, dass das Induktionskochfeld eine vertikale Richtung aufweist, welche rechtwinklig zur Kochfeldplatte und/oder rechtwinklig zu einer der Leiterplatten verläuft, insbesondere zu der Leistungs-Leiterplatte, wobei entlang dieser vertikalen Richtung der Lüfter tiefer als der Kühlkörper angeordnet ist. So wird Bauraum in seitlicher Richtung eingespart. Des Weiteren verläuft die Anschluss-Leiterplatte unterhalb der Leistungs-Leiterplatte bzw. ist unterhalb dieser angeordnet. Die beiden können vorteilhaft parallel zueinander angeordnet sein mit einem Abstand zwischen 0,5 cm und 10 cm. Die Anschluss-Leiterplatte weist den elektrischen Anschluss nach außen auf, vorteilhaft in Form von daran angeordneten Steckern oder Schraubklemmen bzw. sonstigen Klemmen. Schließlich verläuft der Kühlluftkanal mit einer Biegung bzw. mit einer Umlenkung von mindestens 80° oder mindestens 90° zwischen dem Lüfterausgang und dem Kühlkörper, so dass die Kühlluft mindestens einmal um diese mindestens 90° umgelenkt wird. Durch diese Umlenkung der Kühlluft wird zwar die Kühlluftströmung und somit die Kühlwirkung etwas reduziert. Gleichzeitig kann durch einen solchen gebogenen Kühlluftkanal der Bauraum klein bzw. geringer gehalten werden, als wenn er strömungsoptimiert vom Lüfterausgang zu dem Kühlkörper genau geradlinig verlaufen würde.

Somit wird durch die Erfindung eine relativ hohe Integration mit geringem Bedarf an Bauraum erreicht, was den Platzbedarf für das Induktionskochfeld insbesondere unterhalb der Kochfeldplatte und vorzugsweise in seitlicher Richtung verringert und/oder geringhält.

In vorteilhafter Weiterbildung der Erfindung kann der Kühlluftkanal die vorgenannte Biegung bzw. Umlenkung in eine nach oben weisende Richtung haben oder machen, also in Richtung zur Kochfeldplatte. Dies bewirkt, dass der Kühlluftkanal hinter dieser Biegung bzw. Umlenkung höher verläuft als der Lüfterausgang, so dass der Kühlluftkanal bewirkt, dass die Kühlluft an eine über dem Lüfter bzw. dessen Lüfterausgang liegende Stelle gebracht wirkt bzw. strömt. Hier ist dann nämlich der vorgenannte Kühlkörper angeordnet. So wird eine Art zweistöckiger Aufbau erreicht mit dem Lüfter unter dem Kühlkörper, was den Platzbedarf für das Induktionskochfeld zur Seite hin reduzieren kann. Die dadurch möglicherweise vergrößerte Höhe ist weniger problematisch. Vorteilhaft kann sie durch Anordnung der Anschluss-Leiterplatte unterhalb der Leistungs-Leiterplatte, was später noch näher erläutert wird, sogar ausgenutzt werden als eine Art durchgängiges Konzept. So kann ein insgesamt relativ kompaktes und platzsparendes Induktionskochfeld erreicht werden, zumindest was ein Aufnahmegehäuse odgl. für die genannten Leiterplatten aufweist.

In alternativer Ausgestaltung der Erfindung kann der Kühlluftkanal die genannte Biegung bzw. Umlenkung in seitliche Richtung oder mit einer seitlichen Richtungskomponente aufweisen. Dies kann schräg zur Seite und nach oben sein, besonders vorteilhaft auch nur zur Seite hin. Dann verläuft diese Biegung bzw. Umlenkung zumindest teilweise in einer Ebene, die parallel zur Kochfeldplatte ist bzw. die rechtwinklig zur vorgenannten vertikalen Richtung ist. Dabei kann erreicht werden, dass der Lüfterausgang auf derselben Höhe liegt wie der Kühlluftkanal und/oder der Kühlkörper. So kann ein Aufbau erreicht werden, bei dem der Lüfter zumindest nicht notwendigerweise die Höhe des Induktionskochfelds bzw. dessen Aufnahmegehäuse für die Leiterplatte erhöht. Insofern ist das Induktionskochfeld bei dieser Ausgestaltung der Erfindung in seiner Höhe optimiert bzw. verringert.

In beiden vorgenannten Ausgestaltungen kann bevorzugt vorgesehen sein, dass die genannte Biegung bzw. Umlenkung des Kühlluftkanals nicht nur um 90° geht, also sozusagen die Richtung nur teilweise ändert. Vorteilhaft kann sie nämlich um 180° gehen, also sozusagen eine Richtungsumkehr bewirken, allerdings nach oben oder seitlich verschoben. Besonders bevorzugt sind es relativ genau 180° bis auf ±5°, so dass tatsächlich eine Richtungsumkehr erfolgt, was einen besonders kompakten Aufbau bezüglich Höhe oder Breite ermöglicht. Diese Biegung bzw. Umlenkung um 180° liegt insgesamt zwischen Lüfterausgang und Kühlkörper vor. Der Kühlkörper kann dann vorteilhaft direkt hinter der Biegung bzw. Umlenkung von 180° angeordnet sein und beginnen. Diese Umlenkung von 180° kann zwar einerseits in mehreren Stufen vorliegen, beispielsweise einmal um 90° und dann noch einmal um 90°, weil so ein Kühlluftkanal besser in das Induktionskochfeld integriert werden kann. Vorteilhaft liegt der Kühlluftkanal jedoch als gleichmäßige Biegung bzw. Umlenkung vor, so dass er gleichmäßig gerundet sein kann, insbesondere als zwei aneinander anschließende Viertelkreise bzw. insgesamt als ein Halbkreis. So kann an sich der Platzbedarf gering gehalten werden und eine effiziente Kühlluftführung erreicht werden.

In weiterer Ausgestaltung der Erfindung ist der Lüfterausgang radial ausgerichtet bzw. geht tangential von dem Lüfter ab. Zusätzlich oder alternativ kann der Lüftereingang des Lüfters axial ausgerichtet sein, also eine axiale Ansaugung erfolgen. Vorzugsweise verläuft der Lüfterausgang rechtwinklig zur vertikalen Richtung, insbesondere so wie der Kühlluftkanal in diesem Bereich, wo er beginnt. Der Lüftereingang verläuft vorteilhaft entlang der vertikalen Richtung, und zwar nach unten. Besonders vorteilhaft ist der Lüfter an einem Boden und/oder an einer Seitenwand eines Aufnahmegehäuses des Induktionskochfelds angeordnet, so dass er möglichst gut von außen Kühlluft ansaugen kann. Derartige Ausgestaltungen der Lüfter und deren Ansaugung sowie Anordnung sind grundsätzlich im Stand der Technik bekannt. Ein derartiger Lüfter weist vorteilhaft einen Durchmesser bzw. eine Breite auf, die über seiner Höhe bzw. Länge liegt, insbesondere ist der Durchmesser zwischen 50% und 200% größer.

In Ausgestaltung der Erfindung ist der Lüfterausgang in einer Ebene angeordnet, die unterhalb der oberen Leistungs-Leiterplatte verläuft, so dass er unter deren Ebene angeordnet ist. Möglicherweise kann der Lüfter oder einer von mehreren Lüftern des Induktionskochfelds tatsächlich unterhalb der Leistungs-Leiterplatte angeordnet sein, diese also nicht nur höher verläuft, sondern ihn überdeckt. Eine Ebene der unteren Anschluss-Leiterplatte kann durch den Lüfter verlaufen bzw. die beiden Komponenten können in etwa auf gleicher Höhe angeordnet sein. So wird die Raumausnutzung im Induktionskochfeld verbessert. Dieser Lüfter liegt dann vorteilhaft seitlich neben der Anschluss-Leiterplatte, besonders vorteilhaft derart, dass diese keinen Ausschnitt odgl. für den Lüfter benötigt.

Vorzugsweise kann der Lüfter zumindest teilweise direkt unterhalb des Kühlkörpers angeordnet sein. Eine Anordnung unterhalb eines Mittelbereichs des Kühlkörpers, in seiner Längsrichtung gesehen, bewirkt auch eine gute Raumausnutzung. Dennoch kann es vorteilhaft sein, wenn der Lüfter den Kühlkörper nicht direkt mit Kühlluft anbläst, da dies ansonsten unnötige Verwirbelungen und keinen guten Luftstrom durch möglichst den gesamten Kühlkörper hindurch zur Folge haben könnte.

In vorteilhafter Ausgestaltung der Erfindung verläuft nämlich die Kühlluft von vorne nach hinten durch den Kühlkörper bzw. längs durch ihn hindurch. So kann eben eine möglichst gute Kühlung möglichst des gesamten Kühlkörpers erfolgen. Des Weiteren kann so eine Kühlluftführung tatsächlich in Bezug auf einen Einbau des Induktionskochfelds in eine Arbeitsplatte odgl. von vorne nach hinten erfolgen. Dadurch kann die Kühlluft hinten am Induktionskochfeld austreten, so dass ein Benutzer, der vor dem Induktionskochfeld steht, davon nicht betroffen ist. Die Kühlluft kann hier auf bekannte Art und Weise in einem Bereich unterhalb der Arbeitsplatte bzw. zwischen Arbeitsplatte und einem darunter angeordneten Küchenmöbel, Backofen odgl. ausgeblasen werden.

Ein Kühlkörper ist vorteilhaft länglich ausgebildet in einer Richtung von vorne nach hinten, wiederum bezogen auf die vorgenannte Ausbildung und Anordnung des Induktionskochfelds. Seine Länge sollte mindestens zweimal oder dreimal so groß sein wie seine Breite und seine Höhe, so dass er insgesamt als lang anzusehen ist. Die vorgenannten Leistungs-Halbleiter sind dann auch vorteilhaft entlang dieser Länge angeordnet, besonders vorteilhaft einer neben dem anderen, um eine gute und effiziente Kühlung zu gewährleisten.

Bevorzugt weist der Kühlkörper Kühlrippen auf, die nebeneinander bzw. parallel zueinander verlaufen. Die genannte Kühlluft kann dann durch diese Kühlrippen strömen und diese kühlen. Die Kühlrippen wiederum sind an einer Kühlkörperbasis angeordnet bzw. stehen von dieser ab. Vorteilhaft wird ein solcher Kühlkörper auf bekannte Art und Weise durch Strangguss erzeugt bzw. hergestellt. An der genannten Kühlkörperbasis können dann die Leistungs-Halbleiter anliegen.

In Ausgestaltung der Erfindung kann das Induktionskochfeld genau eine Leistungs-Leiterplatte aufweisen. Es kann auch genau eine einzige Anschluss-Leiterplatte aufweisen. Die Trennung dieser beiden Funktionen ermöglicht höhere Sicherheit sowie einfacheren Aufbau. Unter Umständen ist es möglich, beide Leiterplatten zuerst auf einem einzigen Rohling aufzubauen bzw. zu bestücken und sie dann zu trennen, beispielsweise zu zerschneiden. Des Weiteren sind die beiden Leiterplatten durch elektrische Verbinder, insbesondere zur Leistungsübertragung, miteinander elektrisch verbunden. Bevorzugt sind die beiden Leiterplatten parallel zueinander im Induktionskochfeld angeordnet. Zusätzlich oder alternativ können sie eine gleiche Flächenbedeckung bzw. gleiche Größe aufweisen. So kann die Baugröße möglichst gering gehalten werden.

In Weiterbildung der Erfindung kann vorgesehen sein, dass an gegenüberliegenden Seiten der Leistungs-Leiterplatte je eine Kühleinrichtung angeordnet ist, vorteilhaft nahe an einer Außenkante. Jede dieser Kühleinrichtungen kann einen eigenen Kühlkörper aufweisen, die vorteilhaft spiegelsymmetrisch zueinander ausgebildet und angeordnet sind. An jedem dieser beiden Kühlkörper können in entsprechender Weise und auch wiederum spiegelsymmetrisch die gleichen Leistungs-Halbleiter angeordnet sein, insbesondere für einen Wechselrichter und/oder Halbbrücken- oder Brückenschaltungen der Leistungsversorgung. Zur Vereinfachung des Aufbaus können die beiden Kühlkörper aus demselben Grundprofil bestehen, insbesondere sind sie identisch.

In möglicher Weiterbildung der Erfindung kann der Kühlluftkanal in einem unteren Bereich des Kochfelds von einem Aufnahmegehäuse für die beiden Leiterplatten gebildet sein bzw. daran ausgebildet sein. Die untere Leiterplatte, vorteilhaft die Anschluss-Leiterplatte, kann dabei voll in dem Aufnahmegehäuse angeordnet sein, insbesondere knapp oberhalb von deren Boden. Die obere Leistungs-Leiterplatte kann im oberen Bereich des Aufnahmegehäuses angeordnet sein, alternativ in einem darüberliegenden Teil. Das genannte Aufnahmegehäuse bildet eine Biegung bzw. eine Umlenkung von 90° durch eine entsprechend ausgebildete Kanalwandung, bildet hier also direkt einen Teil des Kühlluftkanals. So können zusätzliche Bauteile eingespart werden. In möglicher Weiterbildung der Erfindung kann das Aufnahmegehäuse die genannten Leiterplatten und auch die Kühlkörper bzw. die gesamten Kühleinrichtungen vollständig aufnehmen, ggf. mit einem oben aufgesetzten Ansetzstück, das das Aufnahmegehäuse nach oben fortsetzt. Das Aufnahmegehäuse ist dann, ggf. mit dem Ansetzstück, an der Unterseite der Kochfeldplatte befestigt, vorteilhaft auf übliche Art und Weise mittels angeklebter Halterungen. Die restliche Biegung bzw. Umlenkung des Kühlluftkanals, vorteilhaft mit weiteren 90°, kann oben von einem Ansetzstück oder Aufsatzstück gebildet sein. Dieses wird an dem Aufnahmegehäuse befestigt und kann entlang einer Seite einen Kühlluftkanal bilden, vorzugsweise an beiden Seiten.

In vorteilhafter Weiterbildung der Erfindung kann ein unterer Bereich des Kühlluftkanals, der sich an den genannten Lüfterausgang anschließt, von dem Aufnahmegehäuse gebildet sein. Nach oben kann der Kühlluftkanal entweder von einem Boden eines darüber verlaufenden Gehäuseteils oder Ansetzstücks gebildet sein, alternativ von der Unterseite des Kühlkörpers selbst. Auch in diesem Fall kann der genannte Kühlkörper bis kurz vor oder bis hin die genannte Biegung bzw. Umlenkung verlaufen, damit möglichst früh die Kühlluft in ihn eintreten kann. Der Kühlkörper kann langgestreckt ausgebildet sein und bis an ein hinteres Ende des Gehäuses verlaufen. Der Kühlkörper selbst kann dann einen Teil des Kühlluftkanals bilden, alternativ kann ein Gehäuse separate Wandungen aufweisen, die den Kühlluftkanal begrenzen, und der Kühlkörper verläuft dann innerhalb dieses begrenzten Raumes.

Die Leistungs-Leiterplatte kann vorteilhaft einen Wechselrichter, einen Microcontroller sowie weitere Bauteile aufweisen. Sie weist auch Elektroanschlüsse für die Induktionsheizspulen auf. Bevorzugt sind auch elektrische Anschlüsse für eine Bedieneinrichtung vorgesehen, die dann wiederum separat angeordnet ist, insbesondere auf einem Tragblech angeordnet ist, auf dem auch die Induktionsheizspulen angeordnet sind. Alternativ könnte es Gehäuse geben, das eine Aufnahme für die Bedieneinrichtung direkt integriert hat.

Die Anschluss-Leiterplatte weist vorteilhaft ein Netzteil, den elektrischen Anschluss nach außen für einen Hausanschluss sowie ggf. auch Sicherungen auf, beispielsweise übliche Schmelz-Sicherungen. Der elektrische Anschluss ist dabei derart angeordnet, dass er auch bei ungeöffnetem Induktionskochfeld bzw. Aufnahmegehäuse von außen erreichbar ist. Der elektrische Anschluss kann von einem separaten Deckel odgl. verdeckt werden nach erfolgtem Anschluss.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte und Zwischen-Überschriften beschränkt die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im Folgenden näher erläutert. In den Zeichnungen zeigen:
- Fig. 1: eine vereinfachte Seitenschnittdarstellung durch ein Induktionskochfeld, das in einer Arbeitsplatte eingebaut ist,
- Fig. 2: eine Schrägansicht auf das Induktionskochfeld entsprechend Fig. 1 ohne Tragblech, Induktionsheizspulen und Kochfeldplatte, wobei eine Leistungs-Leiterplatte zu sehen ist,
- Fig. 3: ein oberes Ansetzstück, das die Leistungs-Leiterplatte enthält und auf ein unteres Aufnahmegehäuse aufgesetzt ist,
- Fig. 4: eine Schrägansicht auf das nach oben offene untere Aufnahmegehäuse mit der Anschluss-Leiterplatte darin,
- Fig. 5: eine an der Seite teilgeschnittene etwas flachere Schrägansicht im Vergleich zur Fig. 2 mit Blick auf den Kühlluftkanal, der im oberen Kühlluftkanal in den Kühlkörper geht,
- Fig. 6: eine schematische Seitenansicht auf die Konfiguration entsprechend Fig. 5 mit Verlauf der um 180° umgelenkten Kühlluft, dargestellt durch Pfeile,
- Fig. 7: eine vergrößerte Schnittdarstellung durch das untere Aufnahmegehäuse mit oben aufgesetztem Ansetzstück, Kühlluftkanal und Kühlkörper,
- Fig. 8: eine Schrägansicht von unten auf das Aufnahmegehäuse mit Boden, elektrischem Anschluss und Ansauggittern für die beiden Lüfter,
- Fig. 9: eine schräge Unteransicht einer alternativen Ausgestaltung eines Aufnahmegehäuses mit einer Umlenkung der Kühlluft nur um 90°,
- Fig.10: eine teilgeschnittene Ansicht des Aufnahmegehäuses aus Fig. 9.

### Detaillierte Beschreibung des Ausführungsbeispiels

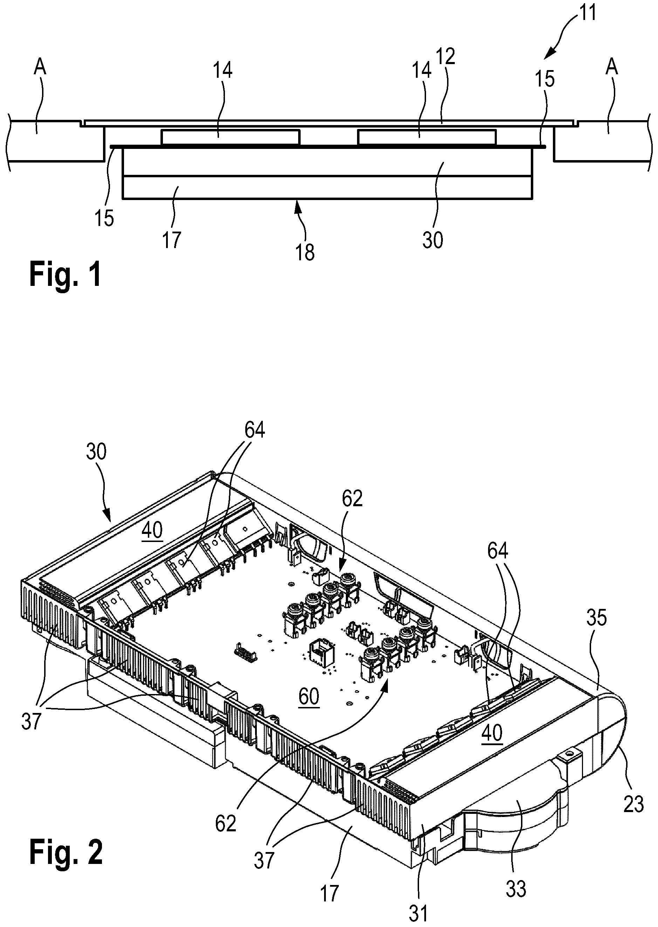

In der Fig. 1 ist im Schnitt dargestellt, wie ein erfindungsgemäßes Induktionskochfeld in einem Ausschnitt in einer Arbeitsplatte A eingebaut ist. Das Induktionskochfeld 11 weist dabei eine Kochfeldplatte 12 auf, die bündig in die Arbeitsplatte A eingelassen ist. Induktionsheizspulen 14 sind von unten gegen eine Unterseite der Kochfeldplatte 12 angedrückt. Diese Induktionsheizspulen 14 liegen auf einem Tragblech 15 auf. Unter dem Tragblech 15 ist ein unteres Aufnahmegehäuse 17 mit oben aufgesetztem Ansetzstück 30 vorgesehen derart, dass das obere Ansetzstück 30 an der Unterseite des Tragblechs 15 anliegt bzw. dieses darauf aufliegt. Zumindest wenn das untere Aufnahmegehäuse 17 und das Ansetzstück 30 als ein Gesamtgehäuse betrachtet werden, ist dieser Aufbau aus dem Stand der Technik bekannt. Das Aufnahmegehäuse 17 und das Ansetzstück 30 sind noch an der Unterseite der Kochfeldplatte 12 befestigt, beispielsweise an dort angeklebte Halterungen angeschraubt odgl..

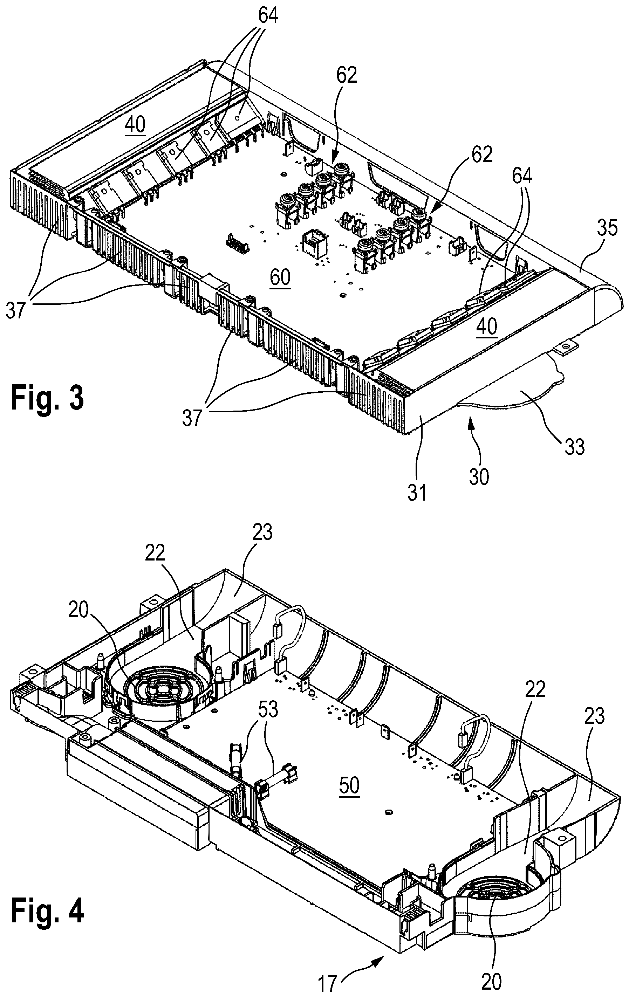

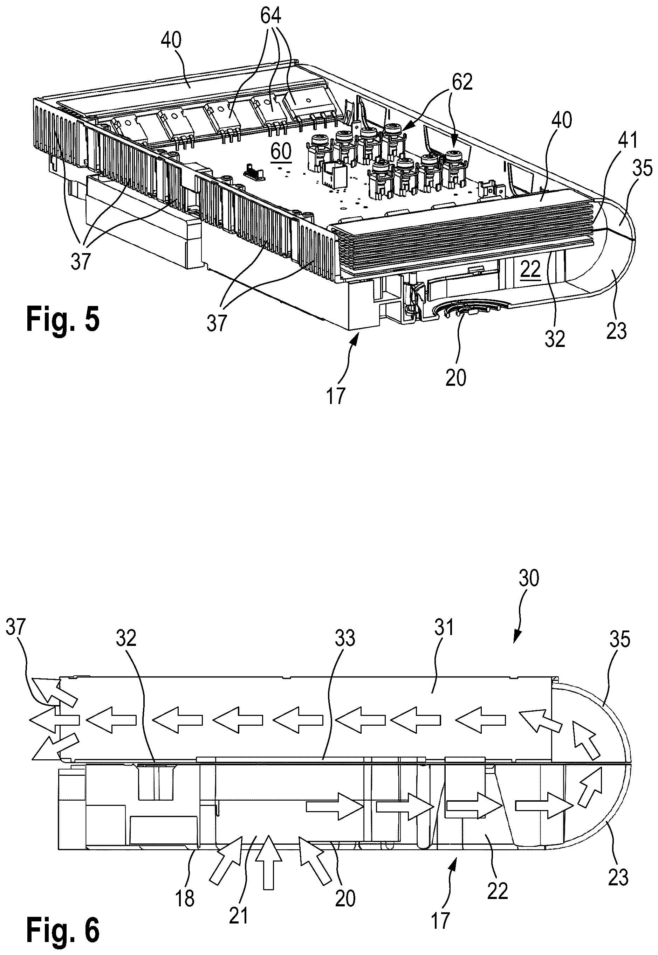

In der Schrägdarstellung der Fig. 2 sind von dem Induktionskochfeld 11 aus Fig. 1 Tragblech 15, Induktionsheizspulen 14 und Kochfeldplatte 12 entfernt. Zu sehen ist die gesamte Aufnahme des Induktionskochfelds 11 bestehend aus dem unteren Aufnahmegehäuse 17, das in der Fig. 4 in derselben Blickrichtung wie Fig. 2 gezeigt ist, und das darauf aufgesetzte obere Ansetzstück 30, das entsprechend in der Fig. 3 gezeigt ist. Im unteren Aufnahmegehäuse 17, das einen Boden aufweist, der weitgehend geschlossen ist bis auf zwei seitlich eingeformte Ansauggitter 20, ist an den Außenseiten von diesen Ansauggittern 20 ausgehend je ein unterer Kühlluftkanal 22 vorgesehen. Er schließt sozusagen jeweils an das Ansauggitter 20 an, wobei über den runden Ansauggittern 20 Lüfter 21 als an sich bekannte Lüfter angeordnet sind. Diese Lüfter saugen Luft axial an und blasen diese angesaugte Luft radial aus. Der untere Kühlluftkanal 22 ist durch seitliche Wandungen und durch den Boden 18 des unteren Aufnahmegehäuses 17 begrenzt und geht in eine untere Viertelrundung 23 über, die eine Umlenkung der ausgeblasenen Luft nach oben beginnen. Diese kann allgemein gerundet sein, vorteilhaft ist sie, wie aus Fig. 6 zu erkennen ist, genau als Viertelkreis gerundet ausgebildet. Nach oben wird der untere Kühlluftkanal 22 von einem Boden 32 des oberen Ansetzstücks 30 geschlossen.

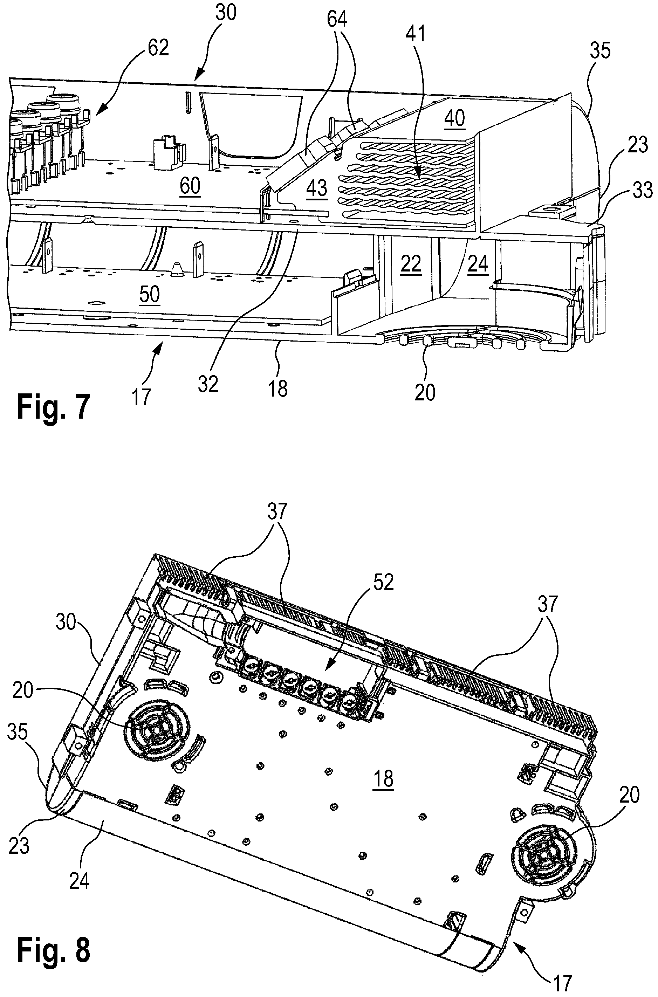

In dem unteren Aufnahmegehäuse 17 ist eine eingangs beschriebene Anschluss-Leiterplatte angeordnet, vorteilhaft auf übliche Art und Weise gehaltert. Die Anschluss-Leiterplatte 50 weist an ihrer Oberseite hier beispielhaft dargestellt zwei Schmelz-Sicherungen 53 auf. Weitere Komponenten wie beispielsweise ein Netzteil bzw. ein Schaltnetzteil können oben auf der Anschluss-Leiterplatte 50 vorgesehen sein. Aus der schrägen Unteransicht der Fig. 8 geht hervor, wie ein eingangs genannter elektrischer Anschluss 52 mit mehreren Schraubklemmen vorgesehen ist, der vorteilhaft auch an der Unterseite der Anschluss-Leiterplatte 50 vorgesehen ist. Der elektrische Anschluss 52 ist in einem Ausschnitt im Boden 32 vorgesehen, und mit diesem kann das Induktionskochfeld 11 elektrisch an einen Hausanschluss angeschlossen werden.

Die Fig. 3 zeigt das obere Ansetzstück 30, das in etwa dieselbe Grundfläche aufweist wie das untere Aufnahmegehäuse 17 und auf diesem befestigt wird und somit die gesamte Aufnahme des Induktionskochfelds 11 bildet. Das obere Ansetzstück 30 weist einen oberen Kühlluftkanal 31 auf, der oberhalb des unteren Kühlluftkanals 22 verläuft. An diesem geht, sozusagen spiegelsymmetrisch zur unteren Viertelrundung 23, eine obere Viertelrundung 35 ab. Durch die beiden Viertelrundungen 23 und 35 wird eine Umkehr des Kühlluftstroms um 180° erreicht, siehe hierzu auch die Fig. 6. Der Boden 32 des Ansetzstücks 30 trennt den unteren Kühlluftkanal 22 und den oberen Kühlluftkanal 31.

Gemäß der Schnittdarstellungen der Fig. 5 und 7 schließt sich im oberen Kühlluftkanal 31 direkt an die obere Viertelrundung 35 ein Kühlkörper 40 an, der somit den oberen Kühlluftkanal 31 weitgehend einnimmt bzw. ausfüllt. Der Kühlkörper 40 ist, wie vor allem die Schnittdarstellung der Fig. 7 zeigt, als spezielles Profil länglich ausgebildet. Er weist zur Mitte des oberen Ansetzstücks 30 hin eine abgeschrägte Kühlkörperbasis 43 auf, von der weitgehend parallel zueinander verlaufende Kühlrippen 41 abstehen, die gewellt ausgebildet sind. Durch deren Zwischenräume strömt die Kühlluft entsprechend Fig. 6. Der obere Kühlluftkanal 31 führt die Luft, die aus dem Kühlkörper 40 bzw. dessen Kühlrippen 41 austritt, zu Ausblasgittern 37 an der Rückwand des oberen Ansetzstücks 30. Im Einbauzustand sind nämlich die Viertelrundungen 23 und 35 vorne bzw. bilden eine Vorderseite des Induktionskochfelds 11, weisen also zu einer Front odgl. eines Möbels hin, auf dem die Arbeitsplatte A aufgelegt ist. Die Ausblasgitter 37 weisen nach hinten, also nach hinten in das genannte Möbel hinein oder in Richtung zu einer Wand.

Das obere Ansetzstück 30 weist, vorteilhaft in derselben Ebene verlaufend wie ein Boden 32, eine seitlich abstehende Lüfterabdeckung 33 auf, die in derselben Richtung weiterläuft. Diese abstehende Lüfterabdeckung 33 deckt gemäß Fig. 6 den Lüfter 21 nach oben ab. Sie ist, wie ein Vergleich der Fig. 2 und 4 zeigt, nur an dem von vorne betrachteten linken Lüfter 21 vorgesehen. Der andere Lüfter 21 ist vollständig von dem Boden 32 des oberen Ansetzstücks 30 abgedeckt.

Des Weiteren weist das obere Ansetzstück 30 eine Leistungs-Leiterplatte 60 auf, auf der beispielhaft Spulenanschlüsse 62 vorgesehen sind, die auch als Schraubklemmen ausgebildet sein können. Sie dienen zum elektrischen Anschluss der Induktionsheizspulen 14.

Des Weiteren sind oben auf der Leistungs-Leiterplatte 60 Leistungs-Halbleiter 64 vorgesehen. Diese sind zur notwendigen Kühlung an die schrägen Bereiche der Kühlkörperbasen 43 der beiden Kühlkörper 40 angelegt zur Kühlung. Weitere vorgenannte Bauteile können ebenfalls auf der Leistungs-Leiterplatte 60 vorgesehen sein. Eine Bedieneinrichtung für das Induktionskochfeld 11 ist vorteilhaft elektrisch per Kabel angeschlossen, ebenso wie die Induktionsheizspulen 14, und kann auf das Tragblech 15 aufgelegt sein. Alternativ kann eine Bedieneinrichtung auch in einem Gehäuse durch eine entsprechende Öffnung in dem Tragblech 15 nach oben stehen.

Aus der Darstellung der Fig. 6 ist zu erkennen, dass die Lüfter 21 in vertikaler Richtung gesehen, welche rechtwinklig zur Fläche der Kochfeldplatte 12 verläuft, tiefer angeordnet sind als die Kühlkörper 40. Insbesondere sind die Lüfter 21 zumindest teilweise unterhalb und somit auch niedriger als die Kühlkörper 40 angeordnet. Dadurch sowie durch den um 180° umgelenkten Verlauf der Kühlluft in dem Kühlluftkanal mit unterem Kühlluftkanal 22 und oberem Kühlluftkanal 31 kann ein kompakter Aufbau des gesamten Induktionskochfelds 11 erreicht werden. Es wird eine gute Durchströmung der Kühlkörper 40 mit Kühlluft erreicht. Durch lange Ausgestaltung der beiden Kühlkörper 40 können sämtliche benötigten Leistungs-Halbleiter 64 auch an diesen angelegt sein, ohne dass sie zu eng beieinander sind. Durch das Vorsehen der beiden übereinander angeordneten Anschluss-Leiterplatte 50 und Leistungs-Leiterplatte 60 ist die Bauhöhe der Kombination von unterem Aufnahmegehäuse 17 und oberem Ansetzstück 30 ohnehin recht hoch, so dass seitlich daneben die Lüfter 21 angeordnet sein können. In einer alternativen Ausgestaltung können auch andere Lüfter verwendet werden.

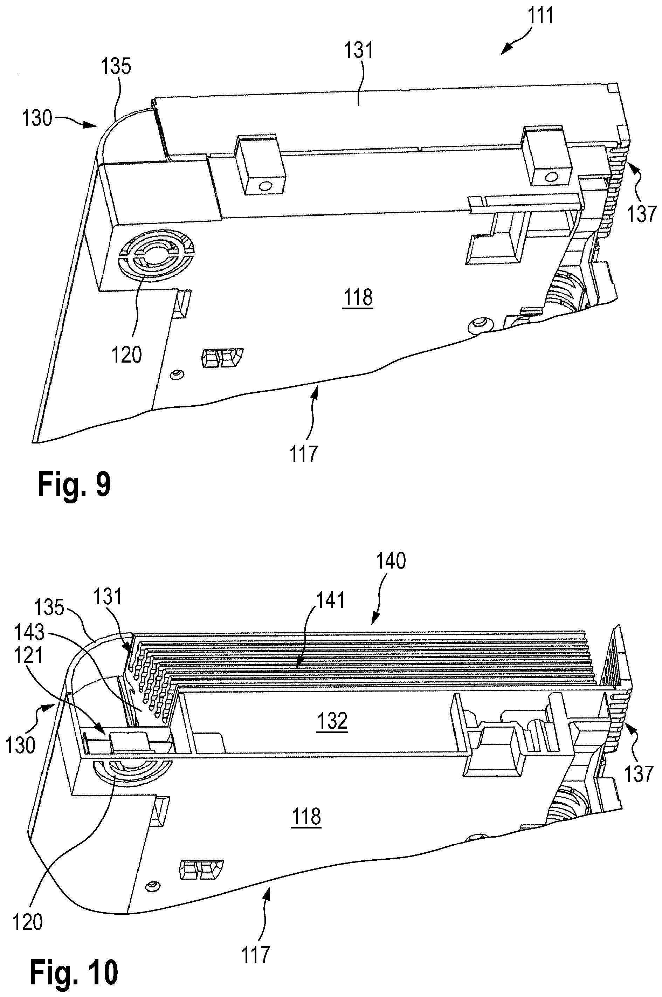

Die Fig. 9 zeigt ähnlich der Fig. 8, allerdings etwas verdreht, eine schräge Unteransicht einer alternativen Ausgestaltung eines Induktionskochfelds 111 mit einem entsprechenden abgewandelten Aufnahmegehäuse 117. Das Aufnahmegehäuse 117 weist einen Boden 118 auf und ein Ansauggitter 120 nahe einer Vorderseite oder Vorderkante in einem vorderen Abschnitt des Aufnahmegehäuses 117. Durch den Teilschnitt der Fig. 10 ist zu erkennen, dass oberhalb dieses Ansauggitters 120 ein Lüfter 121 angeordnet ist, der als reiner Axiallüfter ausgebildet ist, anders als der zuvor beschriebene Lüfter 21. Er saugt also in vertikaler Richtung von unten nach oben die Luft an und bläst sie oben in einen oberen Kühlluftkanal 131 wieder aus. Die vertikal nach oben ausgeblasene Kühlluft wird durch eine obere Viertelrundung 135 des Kühlluftkanals 131 bzw. des oberen Ansetzstücks 130 um 90° nach rechts umgelenkt, also in etwa rechtwinklig. Dort befindet sich der Eingang in einen Kühlkörper 140, der eine Kühlkörperbasis 143 und davon abstehende Kühlrippen 141 aufweist. Dieser Kühlkörper 140 ist ähnlich ausgebildet wie der Kühlkörper 40 entsprechend der Fig. 5. Allerdings sind die Kühlrippen 141 zum Beginn des oberen Kühlluftkanals 131 und über dem Lüfter 121 hin derart schräg abgesägt, dass ein Einströmen von nach oben geblasener und durch die obere Viertelrundung 135 nach rechts umgelenkter Kühlluft in die Zwischenräume zwischen den Kühlrippen 141 möglichst gut erfolgen kann. Dabei wird der Kühlluftkanal 131 im Wesentlichen im Kühlkörper 140 und von einem Boden 132 des oberen Ansetzstücks 130 gebildet.

Dieses Ausführungsbeispiel der Fig. 9 und 10 zeigt also, dass und wie eine Umlenkung der Kühlluft bzw. des Kühlluftkanals mit etwa 90° ausgebildet sein kann. Dadurch wird die Verwendung eines reinen Axiallüfters möglich, welcher evtl. einen stärkeren Luftstrom erzeugen kann und einfacher aufgebaut sein kann. Dies kann eventuell die Leistungsverluste beim Umlenken um 90° kompensieren. Weitere Luftleitbleche oder sonstige Luftführungen könnten in dem relativ kurzen Bereich des Kühlluftkanals 131 zwischen einem Ausgang des Lüfters 121 und einem Eintritt der Kühlluft in den Kühlkörper 140 noch vorgesehen sein. Entsprechende Ausgestaltungen hierfür sind im Stand der Technik ausreichend bekannt. Der Verlauf der Kühlluft innerhalb der wesentlichen Länge des Kühlluftkanals 131 bzw. im Kühlkörper 140 und ihr Austritt hinten aus dem Ausblasgitter 137 kann erfolgen wie zuvor beschrieben. Ebenso kann das gesamte Innenleben innerhalb des Aufnahmegehäuses 117 mit der Anschluss-Leiterplatte 50 und innerhalb des oberen Ansetzstücks 130 mit einer Leistungs-Leiterplatte ausgebildet sein wie zuvor erläutert.

## Patentansprüche

1. Induktionskochfeld mit:
- einer Kochfeldplatte,
- Induktionsheizspulen unter der Kochfeldplatte,
- einer Leistungsversorgung mit Leistungs-Halbleitern für die Induktionsheizspulen,
- einem elektrischen Anschluss nach außen,
- wobei die Leistungsversorgung auf einer Leistungs-Leiterplatte angeordnet ist und der elektrische Anschluss auf einer Anschluss-Leiterplatte angeordnet ist,
- mindestens einer Kühleinrichtung, wobei die Kühleinrichtung aufweist:
- mindestens einen Lüfter mit einem Lüftereingang als Ansaugung und mit einem Lüfterausgang für ausgeblasene Luft zur Kühlung mindestens der Leistungsversorgung,
- einen Kühlluftkanal für die ausgeblasene Luft zur Kühlung, der zumindest teilweise geschlossen ist und der an den Lüfterausgang anschließt,
- mindestens einen Kühlkörper, zu dem der Kühlluftkanal führt, wobei die Leistungs-Halbleiter an dem Kühlkörper zur Kühlung anliegen,
**dadurch gekennzeichnet, dass**
- in einer vertikalen Richtung, die rechtwinklig zur Kochfeldplatte und/oder zu einer der Leiterplatten verläuft, der Lüfter tiefer als der Kühlkörper angeordnet ist,
- die Anschluss-Leiterplatte unterhalb der Leistungs-Leiterplatte verläuft,
- die Anschluss-Leiterplatte einen elektrischen Anschluss nach außen aufweist,
- der Kühlluftkanal mit einer Biegung bzw. Umlenkung von mindestens 90° zwischen dem Lüfterausgang und dem Kühlkörper verläuft.

2. Induktionskochfeld nach Anspruch 1, **dadurch gekennzeichnet, dass** der Kühlluftkanal die Biegung bzw. Umlenkung in Richtung nach oben aufweist derart, dass der Kühlluftkanal hinter der Biegung bzw. Umlenkung höher verläuft als der Lüfterausgang.

3. Induktionskochfeld nach Anspruch 1, **dadurch gekennzeichnet, dass** der Kühlluftkanal die Biegung bzw. Umlenkung zumindest teilweise in einer Ebene rechtwinklig zur vertikalen Richtung aufweist bzw. er derart verläuft, wobei vorzugsweise der Lüfterausgang auf derselben Höhe liegt wie der Kühlluftkanal und/oder der Kühlkörper.

4. Induktionskochfeld nach einem der vorhergehenden Ansprüche, **dadurch gekennzeichnet, dass** die Biegung bzw. Umlenkung des Kühlluftkanals um 180° geht, vorzugsweise zwischen Lüfterausgang und dem Kühlkörper, wobei insbesondere der Kühlkörper direkt hinter der Biegung bzw. Umlenkung von 180° angeordnet ist und beginnt, wobei vorzugsweise die Biegung bzw. Umlenkung von 180° gleichmäßig gerundet ist.

5. Induktionskochfeld nach einem der vorhergehenden Ansprüche, **dadurch gekennzeichnet, dass** der Lüfterausgang des Lüfters radial ausgerichtet ist und/oder der Lüftereingang des Lüfters axial ausgerichtet ist, wobei vorzugsweise der Lüfterausgang rechtwinklig zur vertikalen Richtung ausgerichtet ist und/oder der Lüftereingang entlang der vertikalen Richtung nach unten ausgerichtet ist.

6. Induktionskochfeld nach einem der vorhergehenden Ansprüche, **dadurch gekennzeichnet, dass** der Lüfterausgang in einer Ebene unterhalb der oberen Leistungs-Leiterplatte angeordnet ist, insbesondere der Lüfter vollständig unterhalb der oberen Leistungs-Leiterplatte angeordnet ist, wobei vorzugsweise eine Ebene der unteren Anschluss-Leiterplatte durch den Lüfter verläuft und der Lüfter seitlich neben der Anschluss-Leiterplatte angeordnet ist.

7. Induktionskochfeld nach einem der vorhergehenden Ansprüche, **dadurch gekennzeichnet, dass** der Lüfter zumindest teilweise direkt unterhalb des Kühlkörpers angeordnet ist, insbesondere unterhalb dessen Mittelbereich in Längsrichtung gesehen.

8. Induktionskochfeld nach einem der vorhergehenden Ansprüche, **dadurch gekennzeichnet, dass** die Kühlluft von vorne nach hinten durch den Kühlkörper verläuft, wobei vorzugsweise der Kühlkörper länglich ausgebildet ist in Richtung von vorne nach hinten, wobei insbesondere die Länge des Kühlkörpers mindestens zweimal oder mindestens dreimal so groß ist wie seine Breite und seine Höhe.

9. Induktionskochfeld nach einem der vorhergehenden Ansprüche, **dadurch gekennzeichnet, dass** der Kühlkörper Kühlrippen aufweist, die nebeneinander bzw. parallel zueinander verlaufen mit einem Abstand zueinander, wobei die Kühlluft durch die Kühlrippen strömt, wobei die Kühlrippen an einer Kühlkörperbasis angeordnet sind und von dieser abstehen, und wobei die Leistungs-Halbleiter zur Kühlung an der Kühlkörperbasis anliegen.

10. Induktionskochfeld nach einem der vorhergehenden Ansprüche, **dadurch gekennzeichnet, dass** es genau eine Leistungs-Leiterplatte und genau eine Anschluss-Leiterplatte aufweist, wobei insbesondere Leistungs-Leiterplatte und Anschluss-Leiterplatte parallel zueinander angeordnet sind und/oder mit gleicher Flächenbedeckung bzw. Größe ausgebildet sind.

11. Induktionskochfeld nach einem der vorhergehenden Ansprüche, **dadurch gekennzeichnet, dass** an gegenüberliegenden Seiten der Leistungs-Leiterplatte je eine Kühleinrichtung angeordnet ist, wobei insbesondere die Kühlkörper der Kühleinrichtungen spiegelsymmetrisch ausgebildet und angeordnet sind.

12. Induktionskochfeld nach einem der vorhergehenden Ansprüche, **dadurch gekennzeichnet, dass** der Kühlluftkanal in einem unteren Bereich von einem Aufnahmegehäuse für die beiden Leiterplatten gebildet ist und daran ausgebildet ist, wobei das Aufnahmegehäuse eine Biegung bzw. Umlenkung von 90° bildet durch eine entsprechend ausgebildete Kanalwandung, wobei das Aufnahmegehäuse die Leiterplatten und die Kühlkörper vollständig aufnimmt und an der Unterseite der Kochfeldplatte befestigt ist, wobei die restliche Biegung bzw. Umlenkung von einem Ansetzstück gebildet ist, das an dem Aufnahmegehäuse befestigt ist und nur entlang einer einzigen Seite verläuft, wobei vorzugsweise ein unterer Bereich des Kühlluftkanals, der sich an den Lüfterausgang anschließt, von dem Aufnahmegehäuse gebildet ist, wobei hier der Kühlluftkanal nach oben von einer Unterseite des Kühlkörpers abgedeckt ist, wobei der Kühlkörper bis zum Beginn der Biegung bzw. Umleitung verläuft, wobei der Kühlluftkanal bis an eine hintere Stirnseite des Kühlkörpers an diesem Ende geführt ist.

13. Induktionskochfeld nach Anspruch 12, **dadurch gekennzeichnet, dass** die Kühlluft am gegenüberliegenden Ende aus dem Kühlkörper austritt und aus dem Induktionskochfeld bzw. aus dem Aufnahmegehäuse nach hinten austritt.

14. Induktionskochfeld nach einem der vorhergehenden Ansprüche, **dadurch gekennzeichnet, dass** die Leistungs-Leiterplatte einen Wechselrichter, einen Microcontroller sowie Anzeigeelemente und Bedienelemente einer Bedieneinrichtung für das Induktionskochfeld und Elektroanschlüsse für die Induktionsheizspulen aufweist.

15. Induktionskochfeld nach einem der vorhergehenden Ansprüche, **dadurch gekennzeichnet, dass** die Anschluss-Leiterplatte ein Netzteil, den elektrischen Anschluss nach außen für einen Hausanschluss sowie Sicherungen aufweist.
